# EUROPEAN PATENT APPLICATION

(11) **EP 2 862 959 A1**
(43) Date of publication of application: **22.04.2015**
(21) Application number: 13189523.7
(22) Date of filing: 21.10.2013
(51) Int. Cl.: C23F 1/18, C23C 18/18, C23C 18/54, C23F 1/34, C23F 1/44, C23G 1/10, H01L 21/3213, H05K 3/06, H05K 3/38

(54) **Method of selectively treating copper in the presence of further metal**

(71) Applicant: Atotech Deutschland GmbH, 10553 Berlin (DE)
(72) Inventor: Janssen, Boris Alexander, 12355 Berlin (DE); Bender, Jerome, 10247 Berlin (DE)
(74) Representative: Wonnemann, Jörg

(57) **Abstract**

The present invention relates to a method of selectively treating the surface of copper or copper alloys without affecting other metals, particularly tin. The methods are suited for treating surfaces of copper or copper alloys in order to facilitate subsequent deposition of metal layers and enhance solderability of the surfaces of copper, copper alloys and said subsequently deposited metal layers. The methods are applied to printed circuit boards (PCBs) and lead frames or integrated circuit substrates (IC substrates).

## Description

### Field of the Invention

The present invention relates to methods of selectively treating the surface of copper or copper alloys without affecting other metals, particularly tin. The methods are suited for treating surfaces of copper or copper alloys in order to facilitate subsequent deposition of metal layers and enhance solderability of the surfaces of copper, copper alloys and said subsequently deposited metal layers. The methods are applied to printed circuit boards (PCBs) and lead frames or integrated circuit substrates (IC substrates).

### Background of the Invention

Methods for treating copper and copper alloys are for example etching methods. Methods for etching copper and copper etchants are well known in the art for their use in the manufacture of printed circuit boards (PCBs) and lead frames.

A method for etching copper using an etchant comprising copper (II) ions, chloride ions, ammonium ions and ammonia is disclosed in Printed Circuit Board Materials Handbook (McGraw-Hill, 1997, R. Sedlack, chapter 15, pages 15.10 to 15.12) for the manufacture of PCBs. This etching method is in particular suited for complete removal of parts of a copper layer in order to generate a copper circuit pattern. But it is difficult to control the etching rate and a too high etching rate causes a too high roughness of the etched copper surface. A high surface roughness of the copper layer induces faster formation of an intermetallic phase when coating the etched copper with another metal, e.g. tin, which in turn impairs or prevents soldering. Further, this etching method leads to formation of CuCl, CuO and copper chloride hydroxide on the etched copper surface which interferes with subsequent deposition of metal layers and solderability of the surfaces. In addition, if the etched copper surfaces are coated with a further metal, the metal deposition bath is contaminated by the surface oxides and the alkaline character of the etchant.

A method for selectively etching copper using an etchant comprising citric acid or malic acid and hydrogen peroxide is disclosed in US 2012/0261608 A1 for manufacturing a semiconductor device. The etchant does not affect nickel. But in the given molar ratio of hydrogen peroxide to carboxylic acid of 0.3 to 5 for citric acid or 0.2 to 6 for malic acid the etchant affects tin. While nickel surfaces passivate and are therefore more stable against copper etchants, tin is more susceptible to copper etchants.

A further method for selectively etching copper or copper alloys is disclosed by US 4,144,119 which presents an etchant comprising hydrogen peroxide, phenolsulfonic acid and phosphoric acid. Presence of phosphoric acid prevented simultaneous dissolution of tin. A disadvantage of this etching method is the presence of phenolsulfonic acid. Phenolsulfonic acid used in combination with hydrogen peroxide causes cords and brown residues on the etched surfaces which impair later deposition of metal and soldering. In addition, after some operating time the etchant composition changes due to degradation of constituents and the altered etchant attacks tin.

WO 2002/079542 A2 discloses methods for treating a copper substrate to improve adhesion of polymeric materials thereto, comprising the steps of intergranular etching a surface of the copper substrate; and depositing a metal, for example tin, to the intergranular etched surface by an immersion plating method. One etchant comprises a cupric ion source, an organic acid and a halide ion source. Another etchant comprises i.a. an oxidizer and an acid. None of the etchants selectively etches copper while not affecting tin.

While few of the disclosed etching methods are able to selectively treat copper or copper alloys without affecting tin they lack in reliable long operating times and still lack to provide copper or copper alloy surfaces suited for further deposition of metal layers and for soldering.

### Objective of the present Invention

It is the objective of the present invention to provide a method of selectively treating surfaces of copper or copper alloys without affecting other metals, particularly tin, for obtaining surfaces of copper or copper alloys suited for further deposition of metal layers. It is the further objective of the present invention to provide a method of selectively treating surfaces of copper or copper alloys without affecting other metals, particularly tin, for obtaining surfaces of copper, copper alloys or other metal layers deposited thereon with good solderability. Another objective of the present invention is to provide a method of selectively treating surfaces of copper or copper alloys without affecting other metals, particularly tin, utilizing etchants with a reliable long operating time.

### Summary of the Invention

This objective is solved by a method of selectively treating the surface of copper or copper alloys, comprising the steps of
(i) contacting said surface with an alkaline treatment solution, and
(ii) contacting the surface obtained by step (i) with an acidic treatment solution.

The method according to the present invention selectively treats the surface of copper or copper alloys in the presence of other metals, particularly tin. The surfaces of the other metals, particularly tin, are not affected by the treating method. Furthermore a good adhesion and a good solderability of metal layers are achieved when subsequently deposited onto surfaces of copper or copper alloys treated by the method of the present invention.

### Detailed Description of the Invention

The method of selectively treating the surface of copper or copper alloys according to the present invention comprises the steps of
(i) contacting said surface with an alkaline treatment solution, and
(ii) contacting the surface obtained by step (i) with an acidic treatment solution.

The alkaline treatment solution comprises:
- at least one source of copper (II) ions,
- at least one source of halide ions, and
- ammonia.

The source of copper (II) ions in the alkaline treatment solution is selected from the group comprising copper(II) chloride, copper(II) bromide and copper(II) nitrate.

The concentration of copper (II) ions ranges from 0.1 g/l to 10 g/l, preferably from 0.5 g/l to 8 g/l, more preferably from 1 g/l to 5 g/l. The source of copper (II) ions may be used in a concentration up to its solubility limit. Preferably the source of copper (II) ions is used in a concentration up to 100 g/l.

The halide ion is selected from the group comprising chloride, bromide, fluoride, iodide and mixtures thereof, preferably chloride and bromide, more preferably chloride. The source of halide ions in the alkaline treatment solution is selected from the group comprising ammonium chloride, copper(II) chloride, lithium chloride, sodium chloride, potassium chloride, magnesium chloride, calcium chloride, aluminum chloride, copper(II) bromide, ammonium bromide, lithium bromide, sodium bromide, potassium bromide, magnesium bromide, copper(II) fluoride, ammonium fluoride, sodium fluoride, potassium fluoride, ammonium iodide, sodium iodide and potassium iodide, preferably ammonium chloride, copper(II) chloride, copper(II) bromide, ammonium bromide, more preferably ammonium chloride and copper(II) chloride.

The concentration of halide ions ranges from 5 g/l to 40 g/l, preferably from 7 g/l to 35 g/l. The concentration of halide ions means the sum of the halide ions originating from the source of halide ions and from the source of copper(II) ions if the source of copper(II) ions is selected from a copper(II) halide. The source of halide ions may be used in a concentration up to its solubility limit as long as the molar ratio of copper (II) ions to halide ions is in the range as outlined below.

The molar ratio of copper (II) ions to halide ions is in the range of 1:2 to 1:20, preferably from 1:7 to 1:11, most preferably from 1:8 to 1:10. Within these ranges of molar ratio the copper (II) ions are very well dissolved. If the molar ratio drops below 1:2 copper (I) halide precipitates and the etching rate drops. The molar ratio also may be above 1:20; this has no negative influence on the etching rate.

The concentration of ammonia ranges from 0.05 g/l to 5 g/l, preferably from 0.5 g/l to 3 g/l, more preferably from 1 g/l to 1.5 g/l. The concentration of ammonia may be up to 85 g/l. Ammonia acts as pH adjuster.

The alkaline treatment solution has a pH value ranging from 7.0 to 9.0, preferably from 7.5 to 8.5, more preferably 7.9 to 8.4, even more preferably from 8.0 to 8.3. Below a pH of 7.0 the alkaline treatment solution attacks also tin layers which is unwanted. The pH value may also be above 9 and up to 14. A pH value equal to or below 9 is preferred because above a pH of 9.0 the alkaline treatment solution generates a high amount of oxides on the treated metal surface which is also unwanted because it impairs deposition of further metal layers and solderability.

The alkaline treatment solution may further comprise a source of ammonium ions. The source of ammonium ions is selected from the group comprising ammonium chloride, ammonium bromide, ammonium fluoride and ammonium iodide, preferably ammonium chloride, ammonium bromide, more preferably ammonium chloride.

The concentration of ammonium ions ranges from 0.1 g/l to 130 g/l, preferably from 1 g/l to 50 g/l, preferably from 2 g/l to10 g/l, more preferably from 3 g/l to 6 g/l.

The alkaline treatment solution may further comprise oxygen. Oxygen may be introduced in the alkaline treatment solution by agitation or by bubbling air into the solution.

The alkaline treatment solution may further comprise wetting agents, like amphoteric 400, phosphates, hydrogen phosphates, or carbonates. The concentration of wetting agents ranges from 1 g/l to 10 g/l.

When performing step (i) of the method of the present invention, i.e. when contacting the surface of copper or copper alloys with the alkaline treatment solution, the alkaline treatment solution has a temperature ranging from 15 °C to 90 °C, preferably from 20 °C to 70 °C, more preferably from 20 °C to 50 °C.

Step (i) of the method of the present invention, i.e. contacting the surface of copper or copper alloys with the alkaline treatment solution, is performed for 1 second to 10 minutes, preferably from 10 seconds to 7 minutes, more preferably from 30 seconds to 5 minutes, most preferably from 1 minute to 2 minutes. The periods of contacting the surface of copper or copper alloys with the solutions of the present invention are called contacting time herein.

The contacting time in the alkaline treatment solution depends on the extent of pollution of the surfaces and the thickness of copper or copper alloy removal from the surface. The thickness of copper or copper alloy removal is up to 5 µm, preferably ranges from 0.01 to 3.0 µm, more preferably from 0.1 to 2.0 µm, even more preferably from 0.5 to 1.5 µm, even more preferably from 0.5 to 1.2 µm, even more preferably from 1.0 to 1.5 µm, even more preferably from 1.0 to 1.2 µm. This range of removal enables proper treating of surfaces of copper or copper alloys in order to facilitate subsequent deposition of metal layers and enhance solderability of the surfaces of copper, copper alloys and said subsequently deposited metal layers.

Within the ranges described above the concentration of components, the temperature, the pH of the alkaline treatment solution and the contacting time is chosen in order to adjust the etching rate. The etching rate with the alkaline treatment solution of the present invention ranges from 0.1 µm/minute to 5.0 µm/minute, preferably from 0.1 µm/minute to 3 µm/minute, more preferably from 0.1 µm/minute to 1.5 µm/minute, even more preferably from 0.1 µm/minute to 1.0 µm/minute, even more preferably from 0.5 µm/minute to 1.5 µm/minute. If the treated copper or copper alloy surface is part of a printed circuit board the etching rate preferably ranges from 0.5 µm/minute to 1.0 µm/minute. If the treated copper or copper alloy surface is part of a lead frame the etching rate preferably ranges from 0.1 µm/minute to 1.0 µm/minute. This range of the etching rate enables to proper control the alkaline treatment step in order to achieve the above defined thickness of copper or copper alloy removal from the surface. This range of the etching rate also enables removal of copper or copper alloy from the surface with a uniform thickness within one surface to be etched and also of a plurality of surfaces to be etched present on the same workpiece or on a plurality of workpieces. Workpieces may be PCBs, lead frames or IC substrates having copper or copper alloy surfaces.

Step (i) of the method of the present invention may be directly followed by one or more rinsing steps (i.a) with water. Preferred is deionized water.

Step (i) of the method of the present invention etches copper and the alloy metals, but does not affect already present layers of other metals, particularly tin. This treatment causes a smooth surface of the etched metal. This is a requirement for obtaining good adhesion of further metal layers that may be deposited onto the etched surface after completion of the treatment. In addition, step (i) of the method of the present invention removes pollutions from the surface of copper or copper alloys. The pollutions may be caused by mechanical treatment of the workpieces, like drilling, polishing, brushing, sand-blasting of PCBs or remainder of solder resist masks on PCBs, or like dicing, sawing or punching if the workpiece is a lead frame. The pollutions may result from polymer resins the workpiece is made of or from additives used during mechanical treatment like emulsions for dicing. The removal of pollutions is a further requirement for obtaining good adhesion of further metal layers that may be deposited onto the etched surface. The pollutions may also result from finger prints or wrapping of the workpieces.

Step (i) of the method of the present invention does not remove already present oxides from the surface of copper or copper alloys. Instead it causes additional formation of metal oxides on the surface of copper or copper alloys.

The copper alloy comprises alloying metals and the alloying metals are selected from the group comprising iron, chromium, silicon, zinc, tin, nickel, zirconium and phosphorous.

The conductive paths of lead frames C194, for example, consist of a copper-iron alloy containing about 3 at% (at% means atomic percentage) iron (Cu:Fe:Zn:P = 97.4at%:2.4at%:0.13at%:0.04at%). A further example of lead frames is EFTECH 64T the conductive paths of which consist of a copper-chromium alloy containing about 0.5 at% (Cu:Cr:Sn:Zn = 99.25at%:0.3at%:0.25at%:0.2at%) or C151 the conductive paths of which consist of a copper-zinc alloy containing 99.9at% copper and 0.1 at% zinc.

Thus, the metal oxides formed during step (i) comprise copper oxides and additionally may comprise oxides of the alloying metals like iron oxide or chromium oxides.

The oxides interfere with the subsequent deposition of further metal layers. For example, further deposited tin layers become gray, stained and streaky if too much copper oxides or other metal oxides are on the surface of the copper or copper alloy. This also affects a subsequent soldering step; soldering suffers from poor wetting. The solder does not flow over the whole surface of copper or copper alloy. The adhesion of the solder to the surface of the copper or copper alloy is also poor and mechanical and electrical connection of an integrated circuit to the surface of the copper or copper alloy is insecure. Instead, a further deposited tin layer is to be smooth, bright or semibright, white and stainless.

Step (i) is directly followed by step (ii) of the method of the present invention. Optionally one or more rinsing steps (i.a) are performed between step (i) and step(ii). Step (ii) is the contacting of surfaces of copper or copper alloys with an acidic treatment solution.

The acidic treatment solution comprises at least one acid. The at least one acid in the acidic treatment solution is selected from the group comprising organic acids and mineral acids. Organic acids are selected from the group comprising carboxylic acids or aromatic sulfonic acids. Carboxylic acids are preferred.

Carboxylic acids in the acidic treatment solution are selected from the group comprising carboxylic acids having 1 to 10 carbon atoms, preferably 1 to 6 carbon atoms; and 1 to 3 carboxylic acid groups, and salts of the aforementioned or mixtures thereof. The carboxylic acids may be substituted by one or more functional groups selected from the group of hydroxy group and amino group. Thus, the carboxylic acid is selected from the group comprising monocarboxylic acids, dicarboxylic acids and tricarboxylic acids and salts of the aforementioned or mixtures thereof.

Monocarboxylic acids are selected from the group comprising formic acid, acetic acid, glycolic acid, propanoic acid, butanoic acid, pentanoic acid, gluconic acid, lactic acid, alanine and glycine.

Dicarboxylic acids are selected from the group comprising malonic acid, succinic acid, aspartic acid, malic acid, adipic acid and tartaric acid.

Tricarboxylic acids are selected from the group comprising citric acid and isocitric acid. Citric acid is preferred.

Aromatic sulfonic acids in the acidic treatment solution are selected from the group comprising benzene sulfonic acid, benzyl sulfonic acid, o-toluene sulfonic acid, m-toluene sulfonic acid, p-toluene sulfonic acid, xylene sulfonic acid, and naphthyl sulphonic acid. Preferred are o-toluene sulfonic acid, m-toluene sulfonic acid and p-toluene sulfonic acid.

Mineral acids in the acidic treatment solution are selected from the group comprising phosphoric acid, hydrochloric acid and nitric acid. The preferred mineral acid in the acidic treatment solution is phosphoric acid.

The concentration of the at least one acid ranges from 4 g/l to 500 g/l, preferably from 50 g/l to 300 g/l, more preferably from 50 g/l to 200 g/l. The concentration of the at least one acid may also be higher, for example up to its solubility limit. The concentration of the at least one acid is limited by the viscosity of the acidic treatment solution. The higher the concentration of the acid the higher is the viscosity of the acidic treatment solution. If the viscosity of the acidic treatment solution is too high the etching result is non-uniform throughout the surfaces. In particular, small structures are prone to non-uniform etching if the viscosity of the acidic treatment solution is too high. Thus, the concentration ranges of the at least one acid defined above are in particular suited for treating small-area surfaces or surfaces with small interspaces between them, like in lead frames.

This concentration of the at least one acid is high enough to remove the metal oxides from the surface of copper or copper alloy. In particular this concentration is suited for dissolving the oxides of the alloying metals and especially iron or chromium oxides. Above this concentration of the at least one acid the acidic treatment solution also attacks other metals, particularly tin layers, which is unwanted.

The acidic treatment solution further may comprise an oxidising agent. The oxidising agent in the acidic treatment solution comprises peroxo compounds. The peroxo compounds are selected from the group comprising hydrogen peroxide, disodium peroxodisulfate, dipotassium peroxodisulfate, ammonium peroxodisulfate, sodium caroate and potassium caroate; preferably hydrogen peroxide and disodium peroxodisulfate.

The concentration of the oxidizing agent ranges from 0.25 g/l to 400 g/l, preferably 0.25 g/l to 200 g/l, more preferably from 0.25 g/l to 50 g/l, even more preferably from 0.25 g/l to 25 g/l, most preferably from 0.25 g/l to 12 g/l.

The oxidising agent accelerates the etching. The higher the concentration of the oxidising agent the higher is the etching rate of the acidic treatment solution. The concentration range given above is suited for controlling the etching rate. Above this concentration of the oxidizing agent the acidic treatment solution also attacks other metals, particularly tin layers, which is unwanted. If the concentration of the oxidizing agent is above the defined range, the treated surface shows gray-white stains and soldering is impossible.

The acidic treatment solution may further comprise wetting agents, like amphoteric 400, phosphates, hydrogen phosphates, or carbonates. The concentration of wetting agents ranges from 1 g/l to 10 g/l.

The acidic treatment solution has a pH value ranging from 0 to 2, preferably ranging from 0.5 to 2, more preferably ranging from 1 to 2. If the pH value of the acidic treatment solution is above 2, the etching is too slow.

When performing step (ii) of the method of the present invention, i.e. when contacting the surface of copper or copper alloys with the acidic treatment solution, the acidic treatment solution has a temperature ranging from 15 °C to 30 °C, preferably from 20 °C to 25 °C.

Step (ii) of the method of the present invention, i.e. contacting the surface of copper or copper alloys with the acidic treatment solution, is performed for 3 seconds to 30 minutes, preferably from 10 seconds to 20 minutes, more preferably from 10 seconds to 15 minutes, most preferably from 10 seconds to 6 minutes. Preferably step (ii) of the method of the present invention is performed for a time thrice as long as step (i).

The etching rate of the acidic treatment solution of the present invention ranges from 0.01 µm/minute to 1 µm/minute, preferably from 0.03 µm/minute to 0.5 µm/minute, more preferably from 0.03 µm/minute to 0.1 µm/minute. The concentration of the oxidizing agent and the temperature of the acidic treatment solution influence the etching rate. These parameters are adjusted in order to accelerate the etching rate without affecting also present metals, particularly tin.

Step (ii) of the method of the present invention may be directly followed by one or more rinsing steps (ii.a) with water. Preferred is deionized water.

Step (ii) of the method of the present invention removes metal oxides from the surface of the copper or the copper alloy. The metal oxides may be already present prior to applying the method of the present invention onto the surface of the copper or the copper alloy and/or the metal oxides may be formed during step (i) of the method of the present invention on the surface of the copper or the copper alloy. Removal of the metal oxides is difficult to achieve in particular when copper alloys containing iron or chromium are to be etched. Dissolving iron or chromium oxides usually requires harsh etchants and etching conditions that generally also etch other metals, particularly tin surfaces. In contrast, the acidic treatment solution and the etching conditions of the present invention also enable removal of the oxides of alloying metals, in particular iron and chromium oxides, without etching other metals, particularly tin.

Metal oxides have to be removed in order to obtain surfaces of copper or copper alloys suited for deposition of further metal layers and suited for soldering the surfaces of copper, copper alloys and said further deposited metal layers.

The treating method of the present invention etches surfaces of copper or copper alloys without affecting other metals, in particular tin. Other metals which are not affected by the treating method of the present invention as well are nickel, gold and nickel-gold alloys. The treating method causes a smooth surface of the etched metal free of pollutions. The etched surfaces are also free of oxides of copper and oxides of the alloying metals. The treating method is further able to remove copper or copper alloy from the surface with a uniform thickness. Thus, the treating method of the present invention provides surfaces of copper or copper alloys that are in a condition to enable deposition of further metal layers. The surfaces of the etched copper or copper alloys provide good adhesion to the further deposited metal layers. The treating method of the present invention provides surfaces of copper or copper alloys that are able of being soldered either alone or in connection with further metal layers deposited thereon.

In another embodiment the method of the present invention comprises the further step (iii):
(iii) metal plating the surface obtained by step (ii) by a wet chemical plating method.

The wet chemical plating method is selected from the group comprising an electrolytic, an electroless and an immersion plating method. The electroless or immersion plating methods are preferred.

The metal plated onto the etched surfaces of copper or copper alloys are selected from the group comprising tin, nickel, and alloys thereof. The preferred metal is tin.

Compositions and methods for plating metals onto copper and copper alloy surfaces by wet chemical plating methods are known in the art (Modern Electroplating, Fourth Edition, Editors M. Schlesinger and M. Paunovic, 2000, John Wiley & Sons). Compositions and methods for electrolytic, electroless and immersion plating of tin or tin alloys are described in "The Electrodeposition of Tin and its Alloys" (by M. Jordan, Eugen G. Leuze Publishers, 1995).

Depositing tin or tin alloys by an electroless plating method is preferred. An electroless plating method is to be understood as a metal deposition method that supplies the electrons required for metal ion reduction by a reducing agent in the plating bath.

A bath composition for electroless deposition of tin comprises a source of Sn²⁺ ions, a source of Ti³⁺ ions as reducing agent, at least one organic complexing agent, optionally a stabilizing additive and a pH adjuster (for example "The Electrodeposition of Tin and its Alloys" as mentioned above, pages 93 to 94). A bath composition for electroless deposition of tin alloys additionally comprises a source for an alloying metal ion selected from silver, bismuth, nickel and lead.

The workpiece having surfaces of copper or copper alloys is contacted with the electroless plating bath composition for 30 s to 7200 s, more preferably 300 s to 1800 s. The temperature of the plating bath is held during plating in a range from 40 °C to 95 °C, more preferably 60 °C to 85 °C.

More preferred is depositing tin or tin alloys by an immersion plating method. In an immersion plating method the substrate metal transfers electrons to tin ions in solution which then form metallic tin. Simultaneously the substrate metal dissolves.

A bath composition for immersion deposition of tin onto copper or copper alloy surfaces comprises a source of Sn²⁺ ions, at least one complexing agent and a pH adjuster. For an alkaline composition the complexing agent may be sodium cyanide and the pH adjuster is an alkaline compound, like an alkali metal hydroxide. For an acidic solution the complexing agent may be thiourea and the pH adjuster is an acid, like a mineral acid or an organic acid. Optionally a reducing agent may be added in order to achieve higher deposit thickness. Further organic additives, like wetting agents and/or leveling agents, may be added. For examples of bath compositions refer to "The Electrodeposition of Tin and its Alloys" as mentioned above (pages 89 to 90).

The workpiece having surfaces of copper or copper alloys is contacted with the immerson plating bath composition for 30 s to 7200 s, preferably 300 s to 1800 s. The temperature of the plating bath is held during plating in a range from 65 °C to 85 °C, more preferably 65 °C to 75 °C.

Step (iii) of the method of the present invention may be directly followed by the further method step (iii.a):
(iii.a) rinsing the surface obtained by step (iii).

Step (iii.a) may be performed with deionized water, an alkaline solution, like sodium hydroxide solution of pH 10 to 11, and/or a solution of thiourea.

Steps (iii) or (iii.a) of the method of the present invention may be directly followed by one or more rinsing steps (iii.b) with water. Preferred is deionized water. Rinsing steps (iii.a) and/or (iii.b) are performed at a temperature ranging from 20 °C to 70 °C.

The rinsing step (iii.b) may be directly followed by the further method step (iii.c):
(iii.c) post-treating with an anti-tarnish composition.

The anti-tarnish composition comprises a phosphorous-containing compound.

The post-treating step (iii.c) may be directly followed by one or more rinsing steps (iii.d) with water. Preferred is deionized water. The water may have room temperature. Preferred is deionized water having a temperature ranging from 30 and 70 °C, more preferably from 50 and 70 °C.

Step (iii.d) of the method of the present invention may be directly followed by a drying step (iii.e). Preferred is drying at a temperature ranging from 50 to 80 °C.

An additional method step (ii.b) may be performed after step (ii) and prior to step (iii):
(ii.b) plating the surface obtained by step (ii) with a metal layer of low thickness ranging from 0.01 to 0.1 µm.

Step (ii.b) may be performed directly after step (ii) or after one or more steps (ii.a) and prior to step (iii).

Step (ii.b) is performed by one of the wet chemical plating methods, preferably by an electroless or an immersion plating method. If the metal to be deposited in step (iii) is tin, it is preferred to also deposit tin in step (ii.b) of the present invention.

For depositing tin in step (ii.b) the electroless or the immersion plating method described above can be used. In step (ii.b) the plating is performed at a lower temperature with a lower deposition rate. The thickness of the deposited tin layer is small ranging from 0.01 to 0.1 µm.

Depositing the metal layer of low thickness with a low deposition rate prior to step (iii) prevents corrosion to occur beneath the metal layer. The metal layer of low thickness is a dense and uniform layer that has a lower surface roughness than the subjacent surface of the copper or copper alloy. These properties of the metal layer of low thickness contribute to the good adhesion and the good solderability of the metal layer subsequently to be deposited during method step (iii).

If step (ii.b) is perfomed, step (iii) is performed directly after step (ii.b) without any further steps between step (ii.b) and (iii), for example without rinsing steps. The total thickness of the metal layers deposited in step (ii.b) and step (iii) ranges from 0.8 to 2 µm or even higher.

After method step (iii) the surfaces of copper or copper alloys are in very good condition for soldering. Soldering may performed after one of method steps (iii) to (iii.e) with methods known in the art.

The surfaces of copper or copper alloys selectively treated by the method of the present invention may be part of workpieces. Besides having surfaces of copper or copper alloy the workpieces have surfaces of other metals, particularly tin. The workpieces may be PCBs, lead frames or IC substrates.

### Examples

The present invention is further demonstrated by the following non-limiting examples.

### Example 1: according to invention

20 samples of lead frames were diced. The lead frames were of the type C194. The lead frames already had an electrolytic deposited tin layer of about 9.5 µm thickness on the dap area and the terminals.

The conductor paths of the lead frames are made of a copper-iron alloy containing about 3at% iron. The conductor paths which end in the terminals were cut through by the dicing. Thus, the lateral face of the terminals show the surface of the copper alloy. The copper alloy had a pattern of small grooves resulting from dicing and a black layer of pollutions and metal oxides.

The lead frames were etched with the alkaline treatment solution and afterwards with the acidic treatment solution of the present invention. The compositions of the treatment solutions are outlined below. After treatment with the alkaline treatment solution the copper surfaces were smooth and free of pollutions. But the copper surfaces still had a gray-black layer of copper oxides and iron oxides. After treatment with the acidic treatment solution the copper surfaces showed the typical salmon red copper colour. Thus, the copper surfaces additionally were free of metal oxides. The thickness of the already present tin layers on the dap area and on the terminals were measured by X-ray fluorescence spectroscopy (XRF spectroscopy). XRF spectrospcopy is known to persons skilled in the art. The thickness was 9.5 µm. Thus, nothing of the already present tin was removed from the lead frames during etching of the copper surfaces.

After etching the copper alloy surfaces of the lead frames were plated with tin by immersion tin plating with the commercially available immersion tin plating composition Stannatech 2000 V (product of Atotech GmbH). The composition Stannatech 2000 V is an acidic immersion tin plating bath containing a source of Sn²⁺ ions, a complexing agent, a reducing agent, a wetting agent and a leveling agent.

The tin plating was performed in two steps. Firstly the metal layer of low thickness corresponding to method step (ii.b) was deposited and afterwards the tin layer with the desired thickness according to method step (iii). For both plating steps the same immersion tin plating composition was used.

Thereafter the tin plated lead frames were post-treated with an anti-tarnish composition comprising a phosphorous-containing compound according to method step (iii.c). The tin plated lead frames were rinsed and dried. The etching and plating steps are summarized in Table 1. After tin plating the copper surfaces had the typical appearance of a bright silvery-gray-white tin layer. The copper surfaces were completely covered with tin. The thickness of the immersion tin layers plated onto the copper surfaces were calculated on the basis of treatment time. The deposition rate was known to be about 0.05 µm/minute. Thus, the tin layers deposited by immersion plating had a thickness of about 1 µm. Thus, the etched copper surfaces were perfectly suited for plating a metal layer thereon.

Finally the solderability of the tin plated copper surfaces was tested as follows. A flux of the activated rosin type was applied to the lead frames for 10 seconds.

Afterwards molten solder (composition: 96.5at% Sn / 3.0at% Ag / 0.5at% Cu) was applied at a temperature of 245 °C for 5 seconds. Then the lead frames were rinsed with isopropanol for 5 minutes.

Thereafter an artificial aging step (steam test) was performed by storing the lead frames in a cabinet with 100% relative humidity at 95 °C for 8 hours. All surfaces of the copper alloy areas were completely covered with a shiny, convex layer of solder. Thus, the etched copper surfaces were perfectly suited for soldering and showed excellent wetting.

Also the already present electrolytically deposited tin layers on the dap areas and the terminals of the lead frames were completely covered with shiny, convex layers of solder. Thus, also the already present tin layers exhibited excellent wetting and perfect solderability. The already present tin layers were not negatively influenced by the etching steps or the plating steps of the present invention.

Alkaline treatment solution:
2.5 g/l CuCl₂ x 2 H₂O
10 g/l NH₄Cl
5 ml/l NH₃ (25 % by weight)

Acidic treatment solution:
100 g/l Citric acid monohydrate
50 ml/l H₂O₂ (30 % by weight)

**Table 1: Process steps of treatment according to the invention and plating copper alloy surfaces**

| **Step No.** | **Step** | **Time [min]** | **Temperature** |
|---|---|---|---|
| (i) | Alkaline treatment solution | 2 | RT |
| (i.a) | Rinse with DI water | 1 | RT |
| (i.a) | Rinse with DI water | 1 | RT |
| (ii) | Acidic treatment solution | 2 | 40 °C |
| (ii.a) | Rinse with DI water | 1 | RT |
| (ii.a) | Rinse with DI water | 1 | RT |
| (ii.b) | Stannatech 2000 V | 1 | RT |
| (iii) | Stannatech 2000 V | 16 | 70 °C |
| (iii.a) | Rinse with thiourea solution | 1 | RT |
| (iii.b) | Rinse with DI water | 1 | RT |
| (iii.b) | Rinse with DI water | 1 | RT |
| (iii.c) | Post-treatment with anti-tarnish composition | 10 seconds | 20 - 30 °C |
| (iii.d) | Rinse with DI water | 1 | RT |
| (iii.d) | Rinse with DI water | 1 | RT |
| (iii.d) | Rinse with hot DI water | 2 | 60 °C |
| (iii.e) | Drying | 15 | 65 °C |

| | | | |
|---|---|---|---|
| DI water = deionized water; RT = room temperature, about 20 °C | | | |

### Example 2: comparative

Example 1 was repeated with 10 samples of lead frames of the type C194. In contrast to Example 1 the step of treatment with the acidic treatment solution (step (ii)) was omitted and only the step of treatment with the alkaline treatment solution (step (i)) was performed.

The copper alloy surfaces of the lead frames treated with the alkaline treatment solution were smooth and free of pollutions. But the copper surfaces still had a gray-black layer of copper oxides and iron oxides.

The copper alloy surfaces of the lead frames treated with the alkaline treatment solution were plated with tin as described in Example 1. The tin layer deposited onto the copper alloy surfaces by immersion plating covered the copper surface completely. But the tin layer had a mat and gray appearance. Thus, the tin layer deposited looked different from the tin layer deposited in Example 1 after treatment by the inventive method.

Afterwards the tin layer deposited was covered with a layer of solder as described in Example 1. In contrast to the solder test result in Example 1, in Example 2 the solder layer did not cover the whole copper surface. Parts or all of the copper layers were not covered with solder. Thus wetting of the copper surfaces by solder was poor. In addition, the solder layer had a mat appearance and an irregular surface structure in contrast to the regular convex structure achieved in Example 1. The copper surfaces treated with the alkaline treatment solution only were not suited for soldering.

### Example 3: comparative

Example 1 was repeated with 10 samples of lead frames of the type C194. In contrast to Example 1 and Example 2, the step of treatment with the alkaline treatment solution (step (i)) was omitted and only the step of treatment with the acidic treatment solution (step (ii)) was performed.

The copper alloy surfaces of the lead frames treated with the acidic treatment solution showed a gray-red copper colour. Thus, the copper surfaces were free of metal oxides. But the copper surfaces still had the structure of small grooves resulting from dicing and pollutions.

The copper alloy surfaces of the lead frames treated with the acidic treatment solution were plated with tin as described in Example 1. The tin layer deposited by immersion plating did cover the copper surface only in part. Additionally, the tin layer had a mat and gray appearance as described for Example 2. Thus, the tin layer deposited looked different from the tin layer deposited in Example 1 after treatment by the inventive method. Further, cross sections were prepared from the tin plated copper alloy areas and inspected by electron microscopy. The cross sections showed voids between the tin layer and the copper alloy surface. Thus, no uniform interface was generated between the tin layer and the copper alloy surface.

Afterwards the tin layer deposited was covered with a layer of solder as described in Example 1. In contrast to the solder test result in Example 1, in Example 3 the solder layer had the same appearance as described for Example 2. The solder layer did not cover the whole copper surface. Parts of the copper layer were not covered with solder. The problems in soldering were caused in part by the non-uniform interface generated between the tin layer and the copper alloy surface. In addition, the solder layer had a mat appearance. Thus wetting and solderability of the copper surfaces treated with the acidic treatment solution only was poor.

## Claims

1. A method of selectively treating the surface of copper or copper alloys, comprising the steps of
(i) contacting said surface with an alkaline treatment solution, and
(ii) contacting the surface obtained by step (i) with an acidic treatment solution.

2. The method according to claim 1 wherein the alkaline treatment solution has a pH value ranging from 7.0 to 9.0.

3. The method according to one of the foregoing claims wherein the alkaline treatment solution comprises:
- at least one source of copper (II) ions,
- at least one source of halide ions, and
- ammonia.

4. The method according to one of the foregoing claims wherein the acidic treatment solution comprises at least one acid wherein the at least one acid is selected from the group consisting of carboxylic acids, aromatic sulfonic acids and mineral acids.

5. The method according to one of the foregoing claims wherein the acidic treatment solution comprises at least one acid in a concentration ranging from 50 g/l to 200 g/l.

6. The method according to one of the foregoing claims wherein the copper alloy comprises alloying metals and the alloying metals are selected from the group consisting of iron, chromium, silicon, zinc, tin, nickel, zirconium and phosphorous.

7. The method according to one of the foregoing claims wherein the source of copper (II) ions is selected from the group consisting of copper(II) chloride, copper(II) bromide and copper(II) nitrate.

8. The method according to one of the foregoing claims wherein the source of halide ions is selected from the group consisting of ammonium chloride, copper(II) chloride, lithium chloride, sodium chloride, potassium chloride, magnesium chloride, calcium chloride, aluminum chloride, copper(II) bromide, ammonium bromide, lithium bromide, sodium bromide, potassium bromide, magnesium bromide, copper(II) fluoride, ammonium fluoride, sodium fluoride, potassium fluoride, ammonium iodide, sodium iodide and potassium iodide.

9. The method according to one of the foregoing claims wherein the acidic treatment solution further comprises an oxidising agent.

10. The method according to claim 9 wherein the oxidising agent is selected from the group consisting of hydrogen peroxide and disodium peroxodisulfate.

11. The method according to one of the foregoing claims wherein the alkaline treatment solution has a temperature ranging from 15 °C to 90 °C and wherein the acidic treatment solution has a temperature ranging from 15 °C to 30 °C.

12. The method according to one of the foregoing claims wherein the step (i) is performed for 1 second to 10 minutes and wherein the step (ii) is performed for 3 seconds to 30 minutes.

13. The method according to one of the foregoing claims comprising the further step (iii):
(iii) metal plating the surface obtained by step (ii) by a wet chemical plating method.

14. The method according to claim 13, wherein the wet chemical plating method is selected from the group consisting of an electroless and an immersion plating method.

15. The method according to one of the foregoing claims wherein the surfaces of copper or copper alloys are part of workpieces and the workpieces are selected from the group consisting of printed circuit boards, lead frames and integrated circuit substrates.
